(19) Europäisches Patentamt
European Patent Office
Office européen des brevets

(11) **EP 1 927 863 A1**

(12) **EUROPEAN PATENT APPLICATION**

(43) Date of publication:
**04.06.2008 Bulletin 2008/23**

(51) Int Cl.:
***G01R 15/20*** *(2006.01)*

(21) Application number: **07114256.6**

(22) Date of filing: **13.08.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(30) Priority: **01.12.2006 CN 200610157180**

(71) Applicants:
 • **Hu, WenHao**
   **Buji District**
   **Guangdong, Shenzhen 518112 (CN)**
 • **Zang, YuLun**
   **Buji District**
   **Guangdong, Shenzhen 518112 (CN)**

(72) Inventors:
 • **Hu, WenHao**
   **Buji District**
   **Guangdong, Shenzhen 518112 (CN)**
 • **Zang, YuLun**
   **Buji District**
   **Guangdong, Shenzhen 518112 (CN)**

(74) Representative: **Korga, Leokadia**
   **Kancelaria Rzecznika Patentowego**
   **ul. Bereniki 6/7**
   **44-117 Gliwice (PL)**

(54) **Current measuring device**

(57)    Taught herein is a current measuring device, comprising an insulating cover with an upper opening; a magnetic component; and a Hall-effect component; wherein the magnetic component comprises a left magnetic portion and a right magnetic portion forming an upper gap and a lower gap; the Hall-effect component is disposed in the lower gap; and both the magnetic component and the Hall-effect component are received in the insulating cover. Compared with the prior art, the current measuring device of the invention has a lower magnetic reluctance, which introduces higher measurement sensitivity and accuracy, along with a greater anti-interference ability.

Fig. 1

**Description**

The invention relates to a current measuring device, and particularly to a current measuring device capable of operating without being connected to a powered circuit.

Conventional current measuring devices comprise a tuning fork-shaped magnetic component made of a soft magnetic material and a Hall-effect component disposed in a gap formed by the magnetic component

As an object in which a current is flowing approaches the magnetic component, the Hall-effect component detects the magnetic field generated thereby, and so the current may be determined.

Generally, however, the measurement sensitivity and accuracy of the conventional current measuring devices is low, and the units are prone to outside interference.

In view of the above-described problems, it is one objective of the invention to provide a current measuring device having increased measurement sensitivity and accuracy, and an improved resistance to interference.

To achieve the above objectives, in accordance with one embodiment of the invention, provided is a current measuring device, comprising an insulating cover with an upper opening; a magnetic component; and a Hall-effect component.

In certain classes of this embodiment, the magnetic component comprises a left magnetic portion and a right magnetic portion, which taken together form an upper gap and a lower gap.

In certain classes of this embodiment, the Hall-effect component is disposed in the lower gap; and both the magnetic component and the Hall-effect component are received in the insulating cover.

In certain classes of this embodiment, a measuring space is formed between the upper gap and the lower gap of the magnetic component.

In certain classes of this embodiment, an object the flow-through current of which is to be determined is disposed in the measuring space during a measurement.

In certain classes of this embodiment, the Hall-effect component measures a current of the object the flow-through current of which is to be determined by taking advantage of the Hall effect.

In certain classes of this embodiment, a sectional area of the left magnetic portion received in the upper opening of the insulating cover is greater than that of the remaining parts of the left magnetic portion.

In certain classes of this embodiment, a sectional area of the right magnetic portion received in the upper opening of the insulating cover is greater than that of the remaining parts of the right magnetic portion.

In certain classes of this embodiment, the width of the upper opening of the insulating cover is 10 mm.

In certain classes of this embodiment, the width of the upper gap of the magnetic component is 12 mm.

In certain classes of this embodiment, the width of the lower gap of the magnetic component is determined by the thickness of the Hall-effect component.

In certain classes of this embodiment, the width of the lower gap of the magnetic component is 1 mm.

In certain classes of this embodiment, a sectional area of the left magnetic portion in the vicinity of the Hall-effect component is less than that of the remaining parts of the magnetic portion.

In certain classes of this embodiment, a sectional area of the right magnetic portion in the vicinity of the Hall-effect component is less than that of the remaining parts of the magnetic portion.

In certain classes of this embodiment, the insulating cover is U-shaped.

In certain classes of this embodiment, the magnetic component is U-shaped.

In certain classes of this embodiment, the magnetic component may be directly inserted into the insulating cover.

In certain classes of this embodiment, the magnetic component may operate as a voltage sensor.

Compared with the prior art, the current measuring device of the invention has lower magnetic reluctance, which introduces higher measurement sensitivity and accuracy, along with better anti-interference ability.

The invention is described hereinafter with reference to accompanying drawings, in which:

Fig. **1** is a schematic diagram of a current measuring device according to one embodiment of the invention;

Fig. **2** is a schematic diagram of a current measuring device of a prior art;

Fig. **3** illustrates a comparison between magnetic flux generated by magnetic components according to one embodiment of the invention and according to the prior art; and

Fig. **4** is a component block diagram of a current measuring device according to one embodiment of the invention.

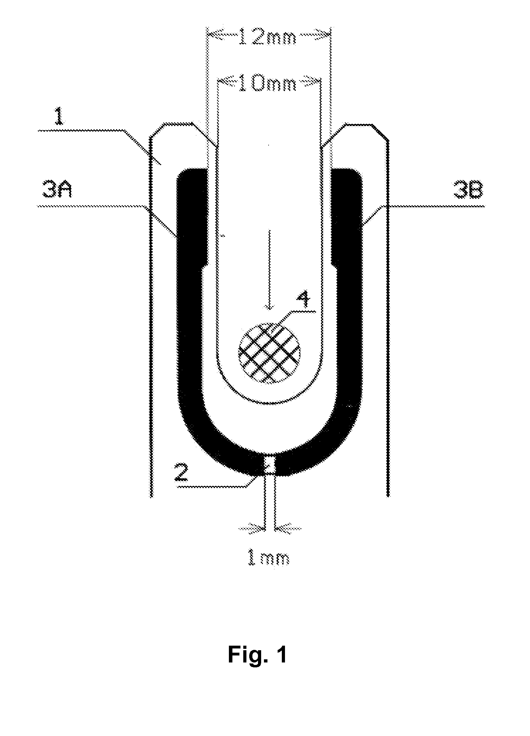

As shown in Fig. **1,** the current measuring device comprises an insulating cover **1,** a magnetic component **3** having an upper opening received in the insulating cover **1,** and a Hall-effect component **2** disposed at the bottom of the magnetic component **3**. The magnetic component **3** comprises a left magnetic portion **3A** and a right magnetic portion **3B,** and an upper gap and a lower gap are formed therebetween. A width of the lower gap is generally determined by a thickness of the Hall-effect component **2.**

In this embodiment, both the insulating cover **1** and the magnetic component **3** are U-shaped, the insulating cover **1** is made of an insulating material, such as a plastic material, and the magnetic component **3** is a magnetic core made of a soft magnetic material.

A measuring space for freely receiving an object the flow-through current of which is to be determined **4** is formed between the upper gap and the lower gap of the magnetic component **3.** In this embodiment, the object the flow-through current of which is to be determined **4** is a live conductor.

As shown in Fig. **1,** the cross-sectional areas of the left magnetic portion **3A** and the right magnetic portion **3B** received in the upper opening of the insulating cover **1** are greater than that of the remaining parts of the left magnetic portion **3A** and the right magnetic portion **3B,** respectively, so as to decrease magnetic reluctance generated thereby.

In Fig. **1,** the cross-sectional area of the left magnetic portion **3A** and the right magnetic portion **3B** in the vicinity of the Hall-effect component **2** is less than that of the remaining parts of the left magnetic portion **3A** and the right magnetic portion **3B,** respectively, so as to converge the magnetic flux onto the Hall-effect component **2.**

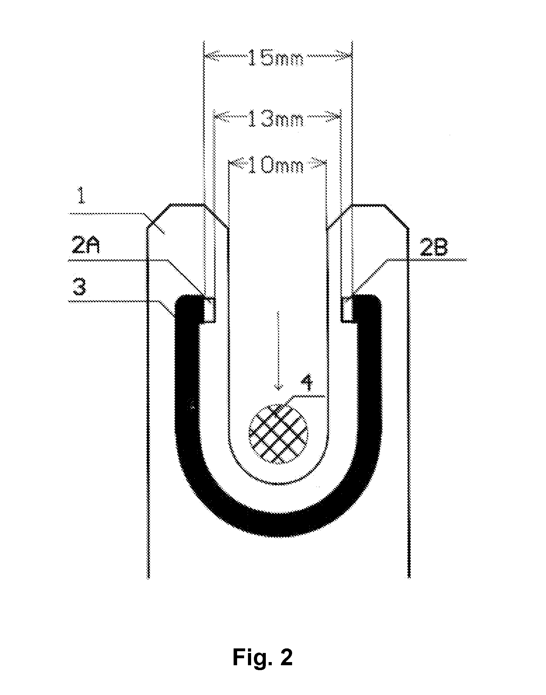

As shown in Fig. **2,** the current measuring device of prior art comprises a U-shaped insulating cover **1,** a U-shaped magnetic component **3** made of a soft magnetic material, and two Hall-effect components **2A** and **2B** disposed in an upper gap of the magnetic component **3.** The cross-sectional area of the magnetic components **3** in the vicinity of the Hall-effect components **2A** and **2B** should match that of the Hall-effect components **2A** and **2B,** so as to converge the magnetic flux thereon.

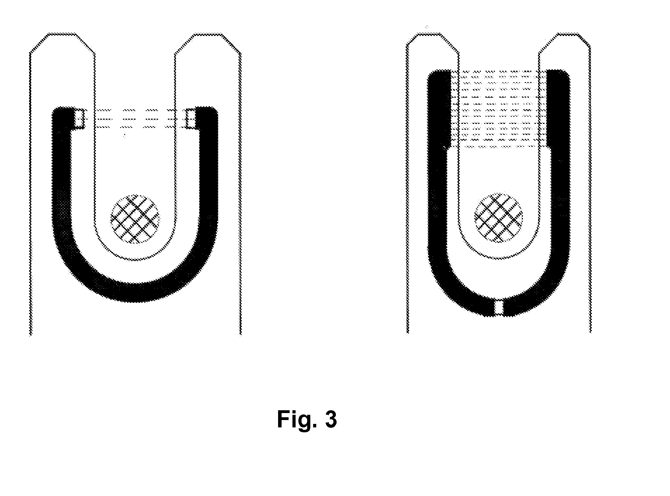

As shown in Fig. **3,** the magnetic reluctance of the current measuring device according to the invention is far less than that of the prior art, which translates into much higher measurement accuracy and sensitivity, along with better anti-interference ability over the prior art.

On the following pages, further explanation of the invention will be given by theoretical analysis on magnetic circuits. This analysis, however, is not intended to limit in any way, shape, or form the scope of this invention.

According to the magnetic principle, assuming a magnetic loop with a sectional area of S, an average diameter of L, and magnetic permeability of p, is wound with N coil turns, as the current I flows therethrough, a magnetic field H generated within the magnetic loop is defined by Eq. (1).

$$\text{H} = \frac{NI}{L} \qquad (1)$$

Since the magnetic field H is parallel to the magnetic loop, under the condition that no magnetic leakage occurs, magnetic flux passing through the cross section $\phi$ is given by Eq. (2),

$$\Phi = B\,S \qquad (2),$$

wherein B is a magnetic induction within the magnetic loop, and $B = \mu H$.

Accordingly,

$$\Phi = BS = \mu S \frac{NI}{L} = NI \div \left(\frac{L}{\mu S}\right) \qquad (3)$$

and

$$\Phi = NI \div \left(\frac{L}{\mu S}\right) \qquad (4)$$

Corresponding to the Ohm's law, the magnetic flux and the magnetomotive force NI are equivalent to the current and the voltage, respectively, and $\dfrac{L}{\mu S}$ is referred to as magnetic reluctance, and is represented by Rm.

In a condition that no magnetic leakage occurs, if an air gap with a length of $L_0$ and a magnetic permeability of $\mu_0$ is disposed in the magnetic loop with a magnetic permeability of $\mu_1$ and a length of $L_1$, then

$$NI = \Phi \left( \frac{L_1}{\mu_1 S_1} + \frac{L_0}{\mu_0 S_0} \right) \qquad (5)$$

wherein $S_1$ and $S_0$ represent the sectional area of the magnetic core 3 and the air gap, respectively.

If there is another gap with a length of $L_{01}$ and an area of $S_{01}$, it can be inferred from equation (5) that

$$NI = \Phi \left( \frac{L_1}{\mu_1 S_1} + \frac{L_0}{\mu_0 S_0} + \frac{L_{01}}{\mu_0 S_{01}} \right) \qquad (6)$$

Taking the devices in Figs. **1** and **2** as example, if a width of the upper opening of the insulating cover **1** is 10 mm, since the magnetic permeability of the magnetic component is far greater than that of the air gap, the magnetic reluctance of the overall magnetic circuit is mainly generated by the air gap. Therefore, if the magnetic reluctance generated by the air gap is reduced, the magnetic reluctance of the entire magnetic circuit will be significantly decreased, which means that during the measurement, the Hall-effect component **2** has a larger signal output, which increases the measurement sensitivity and signal-noise ratio, and improves the anti-interference ability.

As shown in Figs. **1** and **2,** to converge the magnetic flux onto a plane defined by the Hall-effect component **2,** the area of cross sections of magnetic circuits at both sides thereof should match that of the Hall-effect component **2.** Generally, an area of the Hall-effect component **2** should be below 2 mm$^2$. Therefore, the cross-sectional area of the left magnetic portion **3A** and the right magnetic portion **3B** in the vicinity of the Hall-effect component **2** should not be too large.

As shown in Figs. **1** and **2,** a width of the upper opening of the insulating cover **1** is 10 mm, which means that the current measuring device is capable of measuring a live conductor with a maximum diameter of 10 mm. However, since the Hall-effect components **2** in Fig. **2** are disposed at two uppermost ends of the magnetic component **3,** a power lead and an output lead of the Hall-effect component **2** have to be led to a power supply and a signal processing circuit therebehind, which makes the overall circuit complex, and separates the insulating cover **1** into a top portion and a bottom portion. The top portion can only be integrated with the bottom portion via ultrasonic compression until the magnetic component **1,** the Hall-effect component **2,** and the leads are installed. Certain safety standards require that the thickness of the insulator should be less than 1 mm, but it cannot be guaranteed that the thickness of the insulator after the compression meets the requirement in all locations.

As shown in Fig. **1,** insulated materials are firstly molded into a cover, which makes it easy for the magnetic component **3** to be inserted therein, and the Hall-effect component **2** may be directly installed on a same printed circuit board as a power supply and a signal processing circuit. Therefore, the thickness of the insulating cover **1** may be easily restricted within 1 mm.

Assuming the Hall-effect component **2** takes up a length of 1 mm, in Fig. **1,** widths of the upper gap and the lower gap of the magnetic component **3** are respectively 12 mm and 1 mm, in Fig. **2,** a width of the gap of the magnetic component **3** is approximately $10+2\times1+2\times1.5=15$mm.

Next the reluctance generated by the gaps in Fig. **1** will be compared with that in **Fig. 2.** In **Fig. 1,** assuring the sectional area of the left magnetic portion **3A** and the right magnetic portion **3B** in the vicinity of the Hall-effect component **2** is So, the width of the lower gap is $L_0=1$ mm, the width of the upper gap is $L_{01}=12$ mm, and the sectional area of the left magnetic portion **3A** and the right magnetic portion **3B** received in the upper opening of the insulating cover 1 is $S_{01}=kS_0$. Then according to equation (6), the reluctance generated by the upper gap and the lower gap is

$$Rm1 = \frac{L_0}{\mu_0 S_0} + \frac{L_{01}}{\mu_0 S_{01}} = \frac{L_0}{\mu_0 S_0} + \frac{L_{01}}{\mu_0 k S_0} = \frac{1}{\mu_0 S_0} + \frac{12}{\mu_0 k S_0} \qquad (7)$$

In **Fig. 2,** the sectional area of the magnetic portion **3** in the vicinity of the Hall-effect component **2A** and **2B** is So, a width of the gap is $L_0=1$ mm, then according to equation (6), the reluctance generated by the gap is given by

$$Rm2 = \frac{L_0}{\mu_0 S_0} = \frac{15}{\mu_0 S_0} \qquad (8)$$

The ratio between the reluctance of the devices shown in Fig. **1** and that shown in Fig. **2** is given by Eq. 9.

$$\frac{Rm1}{Rm2} = \frac{1 + 12/k}{15} \qquad (9)$$

It can be seen from Eq. (9) that the larger the sectional area of the left magnetic portion **3A** and the right magnetic portion **3B** received in the upper opening of the insulating cover **1,** the less the magnetic reluctance will be. For example, when k is equal to 5, then according to equation (9), the ratio is 1/5, which means that the reluctance of a device according to the invention is only one-fifth of that of the prior art. Moreover, as the value of k increases, the reluctance will further decrease.

Compared with the prior art, the invention enables the overall magnetic circuit to have a lower magnetic reluctance, and therefore has higher measurement sensitivity and accuracy, along with improved anti-interference ability.

Compared with the prior art, the Hall-effect component **2** of the invention is disposed in the lower gap of the magnetic component **3,** and may be installed on a same printed circuit board as the power supply and the signal processing circuit, which allows the current measuring device to have simple structure, convenient installation and low cost. Moreover, an output lead of the Hall-effect component **2** is far from the object the flow-through current of which is to be determined; therefore the influence from the electric field is greatly reduced, which improves the anti-interference ability.

The insulating cover 1 of the invention may be molded into a complete cover without compression, and it thus meets the requirements of certain safety standards. In addition, only one Hall-effect component **2** is employed, which greatly reduces the cost.

The magnetic component **3** and the Hall-effect component **2** are extended to the same printed circuit board as the power supply and the signal processing circuit, therefore the magnetic component **3** may be connected to the signal ground for shielding during the measurement. Meanwhile, as a non-contact voltage sensing function is required, the magnetic component **3** may be disconnected from the signal ground, and connected to an input end of a non-contact voltage sensing circuit. At this point the magnetic component **3** operates as a sensor for sensing an AC voltage.

The current measuring device of the invention is more compact compared with that of prior art, and is especially suitable for a situation with narrow space.

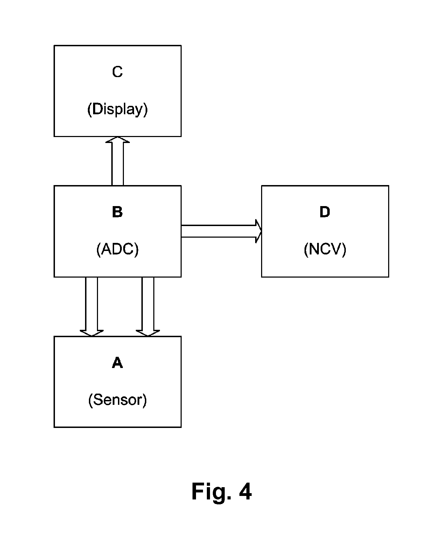

As shown in Fig. **4,** the current measuring device comprises four components: **A, B, C** and **D.** In this embodiment, the component **A** is a current detection component, the component **B** is an analog-digital (A/D) conversion component comprising an operational amplifier and a fast A/D converter, the component **C** is a display, and the component **D** is a non-contact voltage (NCV) sensing circuit.

The component **B** supplies power to a Hall-effect component of the component **A,** the Hall-effect component converts a measured current into a voltage signal, and transmits the voltage signal to operational amplifier of the component **B** for amplification, then an output of the operational amplifier is transmitted to the fast A/D converter for A/D conversion, and processed by a micro-processor, and finally an effective value of the measured current is obtained. The component **B** is capable of detecting an alternating or a direct current.

The component **C** receives and displays measurement results, which comprises the effective value of the measured current, unit symbols and alternating or direct current symbols, from the component **B.**

During the non-contact voltage sensing, the component **D** receives signals from an alternating current voltage sensor, and emits an acoustical or a visual alarm.

While particular embodiments of the invention have been shown and described, it will be obvious to those skilled in the art that changes and modifications may be made without departing from the invention in its broader aspects, and therefore, the aim in the appended claims is to cover all such changes and modifications as fall within the true spirit and scope of the invention.

**Claims**

1. A current measuring device, comprising
   an insulating cover with an upper opening;

a magnetic component; and
a Hall-effect component;
wherein
the magnetic component comprises a left magnetic portion and a right magnetic portion forming an upper gap and a lower gap;
the Hall-effect component is disposed in the lower gap; and
the magnetic component and the Hall-effect component are received in the insulating cover.

2. The device of claim 1, wherein a measuring space is formed between the upper gap and the lower gap of the magnetic component.

3. The device of claim 2, wherein an object the flow-through current of which is to be determined is disposed in the measuring space during measurement.

4. The device of claim 3, wherein the Hall-effect component measures a current of the object the flow-through current of which is to be determined via the Hall effect.

5. The device of claim 1, wherein the sectional area of the left magnetic portion received in the upper opening of the insulating cover is increased.

6. The device of claim 5, wherein the sectional area of the right magnetic portion received in the upper opening of the insulating cover is increased.

7. The device of claim 1, wherein a width of the lower gap of the magnetic component is determined by a thickness of the Hall-effect component.

8. The device of claim 1, wherein the insulating cover is U-shaped.

9. The device of claim 1, wherein the magnetic component is U-shaped.

10. The device of claim 1, wherein the magnetic component is directly inserted into the insulating cover.

**Fig. 1**

**Fig. 2**

**Fig. 3**

**Fig. 4**

European Patent Office

**EUROPEAN SEARCH REPORT**

Application Number

EP 07 11 4256

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 4 704 575 A (ARNOUX DANIEL [FR] ET AL) 3 November 1987 (1987-11-03) * figure 1 * | 1-7,10 | INV. G01R15/20 |
| X | US 2005/237049 A1 (OZAKI SHINJI [JP] ET AL) 27 October 2005 (2005-10-27) * figure 1 * | 1 | |
| X | US 4 179 649 A (COMISKEY GARY F [US] ET AL) 18 December 1979 (1979-12-18) * figures 1,3 * | 1,8,9 | |
| | | | TECHNICAL FIELDS SEARCHED (IPC) |
| | | | G01R |

The present search report has been drawn up for all claims

| Place of search | Date of completion of the search | Examiner |
|---|---|---|
| The Hague | 24 October 2007 | Vytlacilová, Lenka |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 07 11 4256

This annex lists the patent family members relating to the patent documents cited in the above-mentioned European search report.
The members are as contained in the European Patent Office EDP file on
The European Patent Office is in no way liable for these particulars which are merely given for the purpose of information.

24-10-2007

| Patent document cited in search report | | Publication date | Patent family member(s) | | Publication date |
|---|---|---|---|---|---|
| US 4704575 | A | 03-11-1987 | DE | 3667545 D1 | 18-01-1990 |
| | | | EP | 0208590 A1 | 14-01-1987 |
| | | | FR | 2584195 A1 | 02-01-1987 |
| | | | JP | 62042066 A | 24-02-1987 |
| US 2005237049 | A1 | 27-10-2005 | DE | 102005018357 A1 | 10-11-2005 |
| | | | FR | 2869417 A1 | 28-10-2005 |
| | | | KR | 20060045817 A | 17-05-2006 |
| US 4179649 | A | 18-12-1979 | NONE | | |

EPO FORM P0459

For more details about this annex : see Official Journal of the European Patent Office, No. 12/82